(19) Europäisches Patentamt / European Patent Office / Office européen des brevets

(11) **EP 2 985 612 B1**

(12) **FASCICULE DE BREVET EUROPEEN**

(45) Date de publication et mention de la délivrance du brevet:
**15.03.2017 Bulletin 2017/11**

(51) Int Cl.:
***G01R 22/06*** *(2006.01)*

(21) Numéro de dépôt: **15180474.7**

(22) Date de dépôt: **11.08.2015**

(54) **PROCÉDÉ DE DÉTECTION DE FRAUDE DANS UN COMPTEUR ÉLECTRIQUE**

VERFAHREN ZUR BETRUGSERKENNUNG IN EINEM STROMZÄHLER

METHOD FOR DETECTING FRAUD IN AN ELECTRIC METER

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **13.08.2014 FR 1457798**

(43) Date de publication de la demande:
**17.02.2016 Bulletin 2016/07**

(73) Titulaire: **SAGEMCOM ENERGY & TELECOM SAS**
**92500 Rueil-Malmaison (FR)**

(72) Inventeurs:
• **Teboulle, Henri**
**92500 Rueil-Malmaison (FR)**
• **Hergault, Stéphane**
**92500 Rueil-Malmaison (FR)**
• **Regnault, Laurent**
**92500 Rueil-Malmaison (FR)**

(74) Mandataire: **Le Guen-Maillet**
**5, place de Newquay**
**BP 70250**
**35802 Dinard Cedex (FR)**

(56) Documents cités:
**WO-A2-2008/065291**

**Description**

La présente invention concerne un procédé de détection d'une fraude visant à perturber une mesure de consommation électrique par un compteur électrique.

Il est connu que des sources magnétiques, telles que des aimants permanents ou des électro-aimants, peuvent perturber des comportements de dispositifs. Par exemple, il est connu que des champs magnétiques produits par des aimants peuvent fausser des mesures effectuées par un dispositif de métrologie, tel qu'un compteur électrique. Ce principe a été largement utilisé dans des cas de fraude à la consommation électrique : en effet, un individu malintentionné peut placer volontairement un aimant sur un compteur électrique pour fausser des mesures effectuées par ledit compteur électrique de sorte à ce que les mesures effectuées reflètent une consommation électrique bien inférieure à une consommation électrique réelle. Cette technique est aussi utilisée par des individus malintentionnés vis-à-vis d'une nouvelle génération de compteurs électriques, appelés compteurs électriques intelligents (« smart meters » en anglais).

Ce type de fraude est d'autant plus difficile à détecter dans le cas de compteurs électriques intelligents, du fait qu'un attrait des compteurs électriques intelligents est de pouvoir collecter les mesures de consommation électrique à distance sans qu'un agent ait besoin de se déplacer sur site. Il est alors souhaitable de pouvoir détecter de telles fraudes pour, par exemple, pouvoir transmettre une alarme correspondante vers un équipement central de contrôle.

Pour détecter la présence d'un champ magnétique, il est connu d'utiliser des détecteurs de champ magnétique, tels des interrupteurs Reed ou des capteurs à effet Hall. Un interrupteur Reed est un interrupteur magnétique comportant deux contacts en ferronickel, souvent protégés par une couche d'or et de zinc. Les contacts sont élastiques, magnétisés et placés dans une bulle de verre contenant typiquement du diazote. En présence d'un champ magnétique, les contacts sont attirés l'un par l'autre, se rapprochent et se touchent, permettant ainsi un passage de courant. Lorsque le champ magnétique cesse, les contacts s'écartent l'un de l'autre du fait de leur caractère élastique, ce qui interdit le passage de courant. Une présence de champ magnétique peut ainsi être détectée grâce à ce passage de courant.

Dans le cas d'un capteur à effet Hall, un courant électrique traversant un matériau baignant dans un champ magnétique engendre une tension perpendiculaire à celui-ci permettant ainsi de détecter une présence d'un champ magnétique.

Cependant, l'utilisation de capteurs à effet Hall pose des problèmes de fiabilité de détection, et en particulier, selon l'orientation du champ magnétique, la présence d'une source magnétique indésirable peut ne pas être détectée, et ce, même en présence d'une pluralité de capteurs à effet Hall. En effet, des contraintes d'encombrement peuvent ne pas permettre de disposer des capteurs à effet Hall partout où il serait souhaitable de détecter la présence d'une telle source magnétique indésirable.

Par ailleurs, il est décrit dans le brevet suisse CH604183 un procédé de détection de champ magnétique basé sur l'utilisation d'un circuit résonant comprenant un bobinage muni d'un noyau changeant définitivement de valeur d'inductance lorsqu'un champ magnétique apte à saturer le noyau du bobinage lui est appliqué. Ce circuit résonant présente ainsi une fréquence de résonance différente d'une fréquence de résonance de référence si un champ magnétique apte à saturer le noyau du bobinage a été subi par le bobinage. Tout changement de fréquence de résonance permet donc d'identifier l'occurrence d'une fraude. Toutefois, ce circuit résonant ne permet pas de déterminer une étendue de la fraude, i. e. combien de temps a duré la fraude. En effet, une utilisation d'un bobinage changeant définitivement de valeur d'inductance en présence d'un champ magnétique ne permet pas de détecter une fin de fraude ou une reprise de fraude WO 2008/065291 A2 divulgue un compteur d'énergie électrique comprenant au moins un capteur de mesure de courant de type inductif.

Il est souhaitable de pallier ces différents inconvénients de l'état de la technique.

D'une manière générale, il est souhaitable de fournir une solution qui permette de déterminer l'étendue d'une fraude.

Il est notamment souhaitable de fournir une solution qui soit simple à mettre en oeuvre et à faible coût.

Selon un premier aspect de la présente invention, la présente invention concerne un procédé de détection d'une fraude visant à perturber une mesure de consommation électrique par un compteur électrique et consistant à appliquer un champ magnétique dans un voisinage du compteur électrique, le procédé étant mis en oeuvre par un dispositif de détection de fraude associé au compteur électrique, le procédé comprenant les étapes suivantes : déterminer sur une première période de temps une fréquence d'un signal électrique oscillatoire fourni par un oscillateur électrique compris dans le dispositif de détection de fraude et comprenant un bobinage muni d'un noyau ferromagnétique isotrope, le bobinage muni du noyau ferromagnétique isotrope ayant une première valeur d'inductance en l'absence de champ magnétique au voisinage du compteur électrique et ayant au moins une seconde valeur d'inductance, différente de la première valeur d'inductance, en présence au voisinage du compteur électrique d'au moins un champ magnétique apte à modifier une perméabilité magnétique du noyau ferromagnétique isotrope, ladite fréquence du signal électrique oscillatoire dépendant de la valeur d'inductance du bobinage muni du noyau ferromagnétique ; comparer la fréquence du signal électrique oscillatoire déterminée avec au moins une fréquence de seuil, et détecter la fraude en fonction d'un résultat de la comparaison.

L'utilisation dans un oscillateur électrique d'un bobinage muni d'un noyau ferromagnétique isotrope dont la valeur d'inductance change en présence d'un champ magnétique apte à modifier une perméabilité magnétique du noyau ferromagnétique isotrope, mais reprend une valeur initiale lorsque le champ magnétique disparait, permet d'une part de détecter une fraude et d'autre part de détecter l'étendue de la fraude. L'application d'un champ magnétique apte à modifier une perméabilité magnétique du noyau ferromagnétique isotrope provoque en effet une variation de la fréquence du signal électrique oscillatoire produit par l'oscillateur électrique par rapport à une fréquence de fonctionnement de référence (ou fréquence de base) qu'il est possible de détecter. Un retour à la fréquence de base permet de détecter une fin de fraude.

Dans un mode de réalisation, le dispositif de détection de fraude détecte une première fraude lorsque, sur la première période de temps, la fréquence du signal électrique oscillatoire déterminée est supérieure à une fréquence de seuil haute ou lorsque la fréquence du signal électrique oscillatoire déterminée est inférieure à une fréquence d'arrêt d'oscillation inférieure à la fréquence de seuil haute.

De cette manière, un début de fraude est détecté.

Dans un mode de réalisation, suite à la détection de la première fraude sur la première période de temps, le dispositif de détection de fraude détecte une seconde fraude sur une deuxième période de temps suivant la première période de temps, si durant une troisième période de temps intermédiaire entre la première et la seconde période de temps, la fréquence du signal électrique oscillatoire est inférieure à une fréquence de seuil basse et supérieure à la fréquence d'arrêt d'oscillation, la fréquence de seuil basse étant inférieure à la fréquence de seuil haute et supérieure à la fréquence d'arrêt d'oscillation.

De cette manière, le dispositif de détection de fraude est capable de détecter une fin de fraude et de différencier l'occurrence d'une nouvelle fraude d'une continuation d'une fraude déjà détectée.

Dans un mode de réalisation, lors de chaque détermination de la fréquence du signal électrique oscillatoire sur une période de temps, le dispositif de détection de fraude détermine un nombre de passages par zéro sur un front montant et/ou descendant d'un signal résultant d'un échantillonnage du signal électrique oscillatoire pendant ladite période de temps, la fréquence du signal oscillatoire étant fonction du nombre de passages par zéro déterminé pendant ladite période de temps et d'une durée séparant le tout premier instant de passage par zéro pendant ladite période de temps et le tout dernier instant de passage par zéro pendant ladite période de temps,
et en ce que tout passage par zéro est identifié lorsque deux échantillons successifs du signal résultant de l'échantillonnage du signal électrique oscillatoire sont de signes opposés, chaque instant de passage par zéro étant estimé en effectuant une interpolation linéaire entre lesdits échantillons successifs.

L'utilisation d'une interpolation linéaire permet de déterminer précisément un instant de passage par zéro et d'obtenir une estimation précise de la fréquence du signal électrique oscillatoire.

Dans un mode de réalisation, chaque échantillon du signal résultant de l'échantillonnage du signal électrique oscillatoire est associé à une valeur de tension et, lors de la détermination de la fréquence du signal électrique oscillatoire, le dispositif de détection de fraude utilise pour chaque échantillon, une valeur de tension recalée obtenue en soustrayant une valeur de décalage à la valeur de tension associée audit échantillon, la valeur de décalage utilisée pour ledit échantillon étant une moyenne des valeurs de tension associées à une pluralité d'échantillons précédant ledit échantillon dont la valeur de tension est à recaler.

En soustrayant la valeur de décalage de chaque valeur de tension, on supprime un biais qui pourrait perturber la détermination de la fréquence du signal électrique oscillatoire.

Selon un mode de réalisation, lors de chaque détermination de la fréquence du signal électrique oscillatoire sur une période de temps, le dispositif de détection de fraude utilise un dispositif d'écrêtage compris dans le dispositif de détection de fraude pour appliquer une limitation d'une valeur crête à crête au signal électrique oscillatoire afin d'obtenir un signal électrique oscillatoire écrêté et détermine la fréquence du signal électrique oscillatoire en fonction d'un nombre de fronts dans le signal électrique oscillatoire écrêté pendant ladite période de temps.

De cette manière, la détermination de la fréquence du signal électrique oscillatoire est simplifiée.

Selon un mode de réalisation, l'oscillateur électrique est parmi la liste suivante :

- oscillateur de Colpitts,
- oscillateur de Clapp, et
- oscillateur de Hartley.

Chacun de ces oscillateurs comprend un bobinage qu'il est possible de mettre en oeuvre par un bobinage muni du noyau ferromagnétique isotrope et est donc apte à fournir un signal électrique oscillatoire dont la fréquence varie en fonction de la présence d'un champ magnétique apte à modifier une perméabilité magnétique du noyau ferromagnétique isotrope au voisinage dudit bobinage.

Selon un deuxième aspect de la présente invention, la présente invention concerne également un dispositif de détection de fraude visant à empêcher une mesure de consommation électrique par un compteur électrique et consistant à appliquer un champ magnétique dans un voisinage du compteur électrique, le dispositif comprenant:

- des moyens pour déterminer sur une première période de temps une fréquence d'un signal électrique oscillatoire fourni par un oscillateur électrique compris dans le dispositif de détection de fraude et comprenant un bobinage muni d'un noyau ferromagnétique isotrope, le bobinage muni du noyau ferromagnétique isotrope ayant une première valeur d'inductance en l'absence de champ magnétique au voisinage du compteur électrique et ayant au moins une seconde valeur d'inductance en présence d'au moins un champ magnétique apte à modifier une perméabilité magnétique du noyau ferromagnétique isotrope au voisinage du compteur électrique, ladite fréquence du signal électrique oscillatoire dépendant de la valeur d'inductance du bobinage muni du noyau ferromagnétique ;
- des moyens pour comparer la fréquence du signal électrique oscillatoire déterminée avec au moins une fréquence de seuil, et
- des moyens pour détecter une fraude en fonction d'un résultat de la comparaison.

Selon un troisième aspect de la présente invention, la présente invention concerne également un compteur électrique comprenant le dispositif de détection de fraude selon le deuxième aspect.

Selon un quatrième aspect de la présente invention, la présente invention concerne également un système comprenant un compteur électrique selon le troisième aspect et un équipement central de contrôle, le compteur électrique transmettant des informations représentatives d'une fraude à l'équipement central de contrôle.

Selon un cinquième aspect de la présente invention, la présente invention concerne un produit programme d'ordinateur, comportant des instructions pour mettre en oeuvre, par un dispositif, le procédé selon le premier aspect par un processeur du dispositif.

Selon un sixième aspect de la présente invention, la présente invention concerne des moyens de stockage stockant un programme d'ordinateur comportant des instructions pour mettre en oeuvre, par un dispositif, le procédé selon le premier aspect lorsque ledit programme est exécuté par un processeur du dispositif.

Les caractéristiques de la présente invention mentionnées ci-dessus, ainsi que d'autres, apparaîtront plus clairement à la lecture de la description suivante d'un exemple de réalisation, ladite description étant faite en relation avec les dessins joints, parmi lesquels :

- la Fig. 1A illustre schématiquement un système comportant un équipement central de contrôle et un compteur électrique dans lequel la présente invention peut être mise en oeuvre;
- la Fig. 1B illustre schématiquement un compteur électrique comportant un dispositif de détection de fraude selon l'invention ;
- la Fig. 2 illustre schématiquement un premier exemple de dispositif de détection de fraude selon l'invention ;
- la Fig. 3 illustre schématiquement un exemple d'architecture matérielle d'un dispositif de traitement compris dans ledit dispositif de détection de fraude apte à mettre en oeuvre un procédé de détection de fraude selon l'invention;
- la Fig. 4 illustre schématiquement un algorithme, mis en oeuvre par ledit dispositif de traitement, pour détecter la présence d'un champ magnétique au voisinage dudit compteur électrique;
- la Fig. 5 illustre schématiquement un premier algorithme, mis en oeuvre par ledit dispositif de traitement, pour déterminer une fréquence d'un signal électrique oscillatoire fourni par un oscillateur électrique compris dans ledit dispositif de détection de fraude;
- la Fig. 6 illustre schématiquement un exemple d'oscillateur électrique comprenant un bobinage muni du noyau ferromagnétique isotrope ayant une première valeur d'inductance en l'absence de champ magnétique au voisinage du compteur électrique et ayant au moins une seconde valeur d'inductance en présence d'au moins un champ magnétique au voisinage du compteur électrique ;
- la Fig. 7 illustre schématiquement un exemple de courbe représentative d'un signal électrique oscillatoire produit par un oscillateur électrique;
- la Fig. 8A illustre schématiquement un second exemple de dispositif de détection de fraude selon l'invention ; et,
- la Fig. 8B illustre schématiquement un second algorithme, mis en oeuvre par ledit dispositif de traitement, pour déterminer une fréquence d'un signal électrique oscillatoire fourni par un oscillateur électrique compris dans ledit dispositif de détection de fraude.

La description détaillée ci-après s'attache à décrire différents modes de réalisation de la présente invention dans un contexte de compteur électrique, et plus particulièrement dans un contexte de compteur électrique intelligent. Les principes de la présente invention s'appliquent cependant dans un contexte plus large de métrologie sensible aux champs magnétiques, ou plus généralement, de dispositifs dont le fonctionnement peut être perturbé par une présence aux abords dudit dispositif d'un champ magnétique, cette présence de champ magnétique devant par conséquent être détectée.

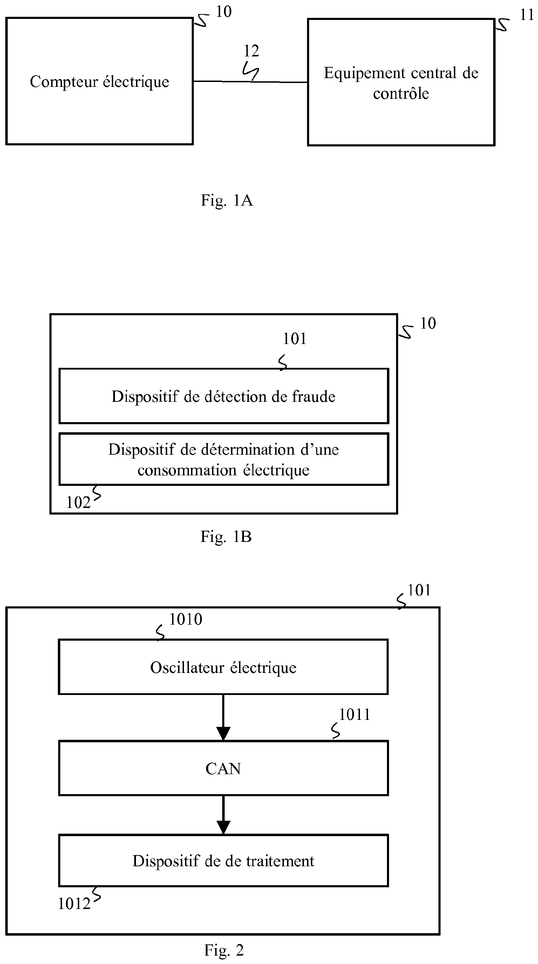

La **Fig. 1A** illustre schématiquement un exemple de système comportant un équipement central de contrôle 11 et un compteur électrique 10 dans lequel la présente invention peut être mise en oeuvre. L'équipement central de contrôle 11 est destiné à contrôler le fonctionnement de compteurs électriques tels que le compteur électrique 10 et notamment :

• à recevoir des informations représentatives d'une consommation électrique mesurée par chaque compteur électrique, et,

- en cas de fraudes faussant des mesures de consommation électrique d'un compteur, à recevoir des informations représentatives de chaque fraude.

Dans l'exemple de système décrit en relation avec la Fig. 1A, l'équipement central de contrôle 11 et le compteur électrique 10 sont reliés par un lien de communication 12 et communiquent en utilisant par exemple un mode de communication par courants porteurs en ligne (CPL).

Dans un mode de réalisation particulier, le compteur électrique 10 fonctionne de manière autonome pour tout ce qui concerne la détection de fraudes. Dans ce mode de réalisation, l'occurrence d'une fraude peut être signalée par l'allumage d'une diode électroluminescente comprise dans le compteur électrique 10 (DEL : Light-Emitting Diode (LED) en terminologie anglo-saxonne) et/ou par un affichage d'informations représentatives de chaque fraude sur un afficheur compris dans le compteur électrique 10.

La **Fig. 1B** illustre schématiquement un compteur électrique, tel que le compteur électrique 10, comportant un dispositif de détection de fraude 101 selon l'invention. Le compteur électrique 10 comprend un dispositif de détermination d'une consommation électrique 102. Le dispositif de détermination de la consommation électrique 102 est sensible aux champs magnétiques qui pourraient être appliqués au voisinage du compteur électrique 10. Par ailleurs, le compteur électrique 10 peut comprendre un dispositif de communication, tel qu'un dispositif de communication CPL, permettant de communiquer avec le dispositif central de contrôle 11, une diode électroluminescente et/ou un afficheur (non représentés) tels que décrits plus haut.

Dans un mode de réalisation particulier, le dispositif de détection de fraude 101 n'est pas compris dans le compteur électrique 10, mais est un dispositif indépendant du compteur électrique 10 qui peut être ajouté sur le compteur électrique 10 ou positionné dans un voisinage du compteur électrique 10. Le dispositif de détection de fraude 101 doit toutefois être suffisamment proche du compteur électrique 10 pour qu'un champ magnétique affectant le compteur électrique 10 affecte de manière identique le dispositif de détection de fraude 101.

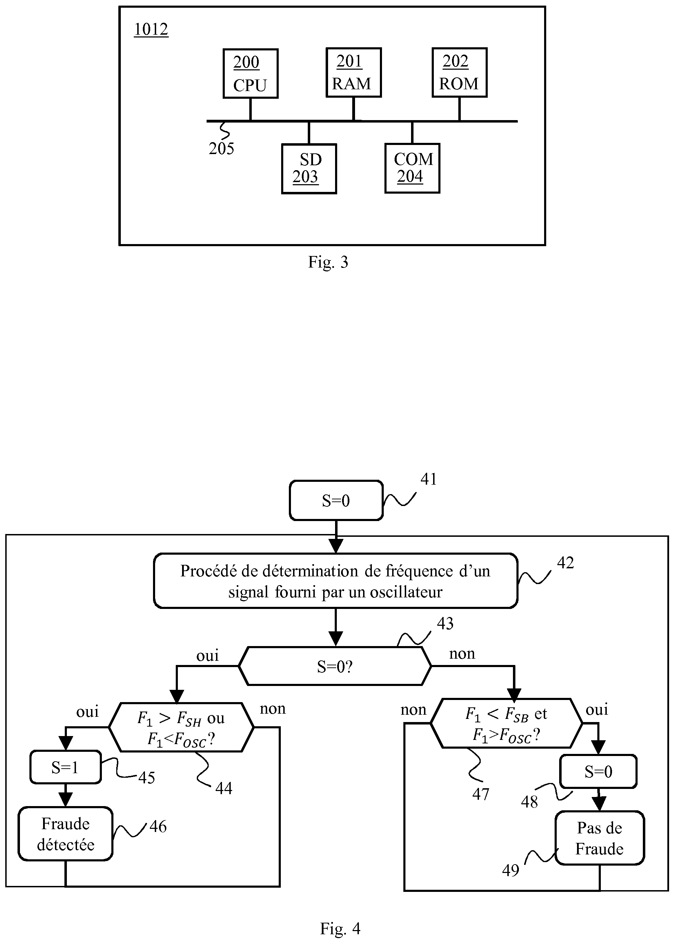

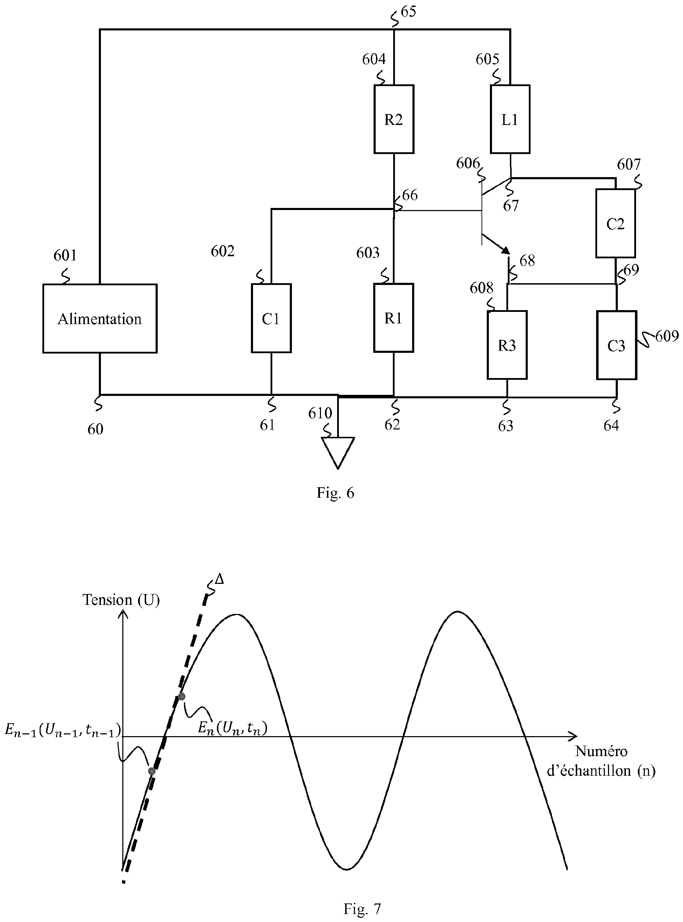

La **Fig. 2** illustre schématiquement un premier exemple de dispositif de détection de fraude 101 selon l'invention. Le dispositif de détection de fraude 101 comprend un oscillateur électrique 1010 dont un exemple est décrit en relation avec la Fig. 6, un convertisseur analogique/numérique (CAN) 1011 et un dispositif de traitement 1012 décrit en relation avec la Fig. 3.

L'oscillateur électrique 1010 fournit un signal électrique oscillatoire au CAN 1011 avec une fréquence $F_1$ dépendant de la présence d'un champ magnétique au voisinage du compteur électrique 10. En l'absence de champ magnétique, la fréquence $F_1$ du signal électrique oscillatoire prend une valeur connue, dite « fréquence de base ».

Lorsqu'il reçoit le signal électrique oscillatoire, le CAN 1011 échantillonne le signal électrique oscillatoire à une fréquence d'échantillonnage $F_E$ très supérieure à la fréquence de base.

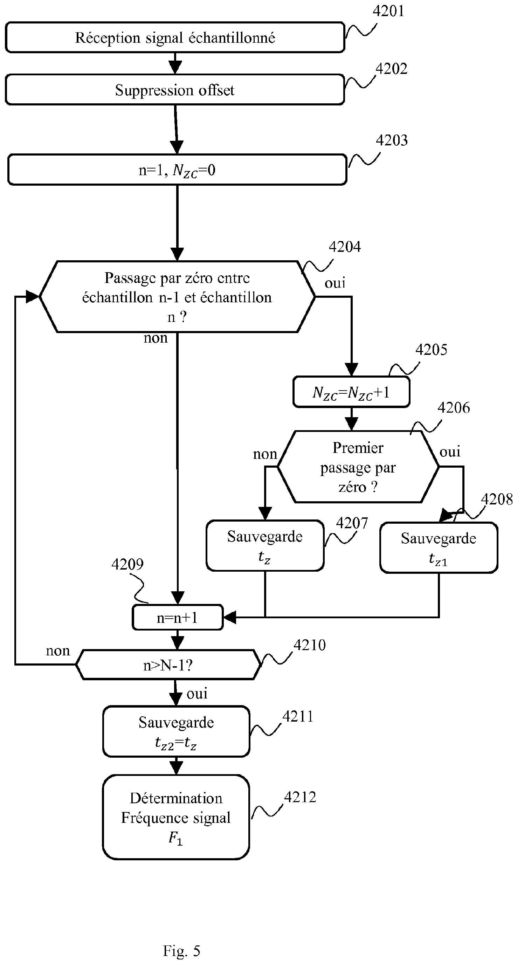

Le signal électrique oscillatoire échantillonné est ensuite fourni au dispositif de traitement 1012. Le dispositif de traitement 1012 détermine la fréquence $F_1$ du signal électrique oscillatoire selon un procédé décrit en relation avec la Fig. 5, compare la fréquence $F_1$ du signal électrique oscillatoire à au moins une fréquence de seuil et détecte une fraude en fonction d'un résultat de la comparaison.

Dans un mode de réalisation, l'oscillateur électrique 1010 est un oscillateur de Collpits décrit dans le brevet américain US1624537 que nous décrivons en relation avec la **Fig. 6.** Dans une portion de circuit comprise entre un point 60 et un point 65, l'oscillateur de Collpits comprend une alimentation 601. Dans une portion de circuit comprise entre le point 65 et un point 66, l'oscillateur de Collpits comprend une résistance 604 de valeur R2. Dans une portion de circuit comprise entre le point 66 et un point 61, l'oscillateur de Collpits comprend un condensateur 602 de valeur C1. Dans une portion de circuit comprise entre le point 66 et un point 62, l'oscillateur de Collpits comprend une résistance 603 de valeur R1. Dans une portion de circuit comprise entre le point 66, un point 67 et un point 68, l'oscillateur de Collpits comprend un transistor 606. Dans une portion de circuit comprise entre le point 68 et un point 63, l'oscillateur de Collpits comprend une résistance 608 de valeur R3. Dans une portion de circuit comprise entre le point 67 et un point 69, l'oscillateur de Collpits comprend un condensateur 607 de valeur C2. Dans une portion de circuit comprise entre le point 69 relié au point 68 et un point 64, l'oscillateur de Collpits comprend un condensateur 609 de valeur C3. Les points 60, 61, 62, 63 et 64 sont reliés à une masse 610.

Dans le cadre de l'invention, dans une portion de circuit comprise entre le point 65 et le point 67, l'oscillateur de Collpits comprend un bobinage 605 muni d'un noyau ferromagnétique isotrope.

La fréquence $F_1$ du signal électrique oscillatoire produit entre les points 67 et la masse est donnée par la relation suivante :

$$F_1 = \frac{1}{2\pi\sqrt{L1\left(\frac{C2.C3}{C2+C3}\right)}}$$

Le bobinage 605 muni d'un noyau ferromagnétique isotrope possède une propriété particulièrement intéressante pour l'invention qui est d'avoir une valeur d'inductance $L1$ variable dépendant de la présence d'un champ magnétique au voisinage dudit bobinage. La fréquence $F_1$ du signal électrique oscillatoire varie donc en fonction de la présence d'un champ magnétique au voisinage dudit bobinage (i.e. au voisinage du compteur électrique 10). Cette propriété est au coeur de l'invention puisqu'elle permet d'identifier la présence d'un champ magnétique au voisinage du compteur électrique 10 en détectant des variations de la fréquence $F_1$ du signal électrique oscillatoire.

Un bobinage possède une valeur d'inductance proportionnelle à une perméabilité magnétique $\mu$, où $\mu=\mu_0 \cdot \mu_r$, $\mu_0$ étant une constante représentant la perméabilité magnétique du vide. $\mu_r$ dépend du noyau du bobinage. Pour un bobinage à air, $\mu_r=1$, donc $\mu=\mu_0$. Pour un bobinage à ferrite, $\mu_r$ dépend d'un matériau utilisé pour la ferrite. Une perturbation magnétique externe a pour effet de diminuer $\mu_r$ et donc de diminuer la valeur d'inductance du bobinage.

Le bobinage 605 muni d'un noyau ferromagnétique isotrope possède donc une première valeur d'inductance en l'absence de champ magnétique au voisinage dudit bobinage 605 (i.e. en l'absence de champ magnétique au voisinage du compteur électrique 10) et au moins une seconde valeur d'inductance différente de la première valeur d'inductance, en présence au voisinage dudit bobinage 605 d'au moins un champ magnétique suffisamment puissant (i.e. apte à modifier la perméabilité magnétique du noyau ferromagnétique isotrope)(i.e. en présence au voisinage du compteur électrique 10 d'au moins un champ magnétique suffisamment puissant (i.e. apte à modifier la perméabilité magnétique du noyau ferromagnétique isotrope)), chaque seconde valeur d'inductance étant inférieure à la première valeur d'inductance. En l'absence d'un champ magnétique, l'oscillateur électrique 1010 fournit un signal électrique oscillatoire avec une fréquence $F_1$ correspondant à la fréquence de base. Une diminution de la valeur de l'inductance $L1$ dudit bobinage 605 entraîne donc une augmentation de la fréquence $F_1$ du signal électrique oscillatoire par rapport à la fréquence de base.

On peut remarquer toutefois que dans certain cas, un champ magnétique peut aussi avoir pour effet d'empêcher l'oscillateur électrique 1010 de fournir un signal électrique oscillatoire, la fréquence $F_1$ devenant nulle.

Selon un mode de réalisation particulier, l'oscillateur électrique 1010 peut aussi être mis en oeuvre par un autre type d'oscillateur électrique tel que par exemple un oscillateur de Clapp (J. K. Clapp, "An inductance-capacitance oscillator of unusual frequency stability", Proc. IRE, vol. 367, pp. 356-358, Mar. 1948) ou un oscillateur de Hartley décrit dans le brevet américain US1356763, sans changer le principe de l'invention.

La **Fig.3** illustre schématiquement un exemple d'architecture matérielle du dispositif de traitement 1012 compris dans le dispositif de détection de fraude 101 apte à mettre en oeuvre un procédé de détection de fraude selon l'invention tel que le procédé de détection de fraude décrit en relation avec la Fig. 4.

Selon l'exemple d'architecture matérielle représenté à la Fig. 3, le dispositif de traitement 1012 comprend alors, reliés par un bus de communication 205: un processeur ou CPU (« Central Processing Unit » en anglais) 200 ; une mémoire vive RAM (« Random Access Memory » en anglais) 201 ; une mémoire morte ROM (« Read Only Memory » en anglais) 202 ; une unité de stockage ou un lecteur de support de stockage, tel qu'un lecteur de cartes SD (« Secure Digital » en anglais) 203 ; au moins une interface de communication 204 permettant au dispositif de traitement 1012 de recevoir des valeurs représentatives d'échantillons du signal électrique oscillatoire échantillonné de la part du CAN 1011, et permettant éventuellement de communiquer, directement ou indirectement, avec l'équipement central de contrôle 11 pour envoyer des informations représentatives de fraudes.

Le processeur 200 est capable d'exécuter des instructions chargées dans la RAM 201 à partir de la ROM 202, d'une mémoire externe (non représentée), d'un support de stockage (tel qu'une carte SD), ou d'un réseau de communication. Lorsque le dispositif de traitement 1012 est mis sous tension, le processeur 200 est capable de lire de la RAM 201 des instructions et de les exécuter. Ces instructions forment un programme d'ordinateur causant la mise en oeuvre, par le processeur 200, de tout ou partie des algorithmes et étapes décrits ci-après en relation avec les Figs. 4, 5 et 8B.

Tout ou partie des algorithmes et étapes décrits ci-après en relation avec les Figs. 4, 5 et 8B peut être implémenté sous forme logicielle par exécution d'un ensemble d'instructions par une machine programmable, par exemple un DSP (« Digital Signal Processor » en anglais) ou un microcontrôleur, ou être implémenté sous forme matérielle par une machine ou un composant dédié, par exemple un FPGA (« Field-Programmable Gate Array » en anglais) ou un ASIC (« Application-Specific Integrated Circuit » en anglais).

La **Fig. 4** illustre schématiquement un algorithme, mis en oeuvre par le dispositif de traitement 1012, pour détecter la présence d'un champ magnétique au voisinage du compteur électrique 10. Lors d'une étape 41, le dispositif de traitement 1012 initialise une variable $S$ à la valeur « 0 ». Dans une étape 42, le dispositif de traitement 1012 met en oeuvre un procédé de détermination de la fréquence $F_1$ du signal électrique oscillatoire fourni par l'oscillateur électrique 1010 décrit en relation avec la Fig. 5. Dans une étape 43, lorsque la fréquence $F_1$ du signal oscillatoire est déterminée, le dispositif de traitement 1012 détermine si la variable $S$ est à la valeur « 0 ».

Si la variable $S$ est à la valeur « 0 », le dispositif de traitement 1012 compare lors d'une étape 44 la fréquence $F_1$ du signal électrique oscillatoire à au moins une fréquence de seuil comprenant une fréquence de seuil haute $F_{SH}$ et/ou à une fréquence d'arrêt d'oscillation $F_{osc}$. La fréquence de seuil haute $F_{SH}$ est une fréquence supérieure à la fréquence de base au-delà de laquelle il est considéré qu'un champ magnétique suffisant pour perturber significativement la mesure de la consommation électrique par le compteur électrique 10 est présent au voisinage du compteur électrique 10. La fréquence de seuil haute $F_{SH}$ est par exemple déterminée empiriquement lors d'une phase de réglage du compteur électrique 10 en appliquant un champ magnétique variable au voisinage du compteur électrique 10. Par exemple, la fréquence de seuil haute $F_{SH}$ correspond à une fréquence au-delà de laquelle un pourcentage d'une consommation électrique réelle, supérieur à un seuil prédéfini, n'est pas mesuré par le compteur. Ledit seuil peut par exemple être fixé à «0.1%» de la consommation électrique. La fréquence d'arrêt d'oscillation $F_{osc}$ est une fréquence inférieure à la fréquence de base en dessous de laquelle il est considéré que le signal électrique produit par l'oscillateur électrique 1010 n'est plus un signal électrique oscillatoire. La fréquence d'arrêt d'oscillation $F_{osc}$ est une fréquence prédéfinie par convention.

Si suite à l'étape 44, il apparaît que la fréquence $F_1$ du signal électrique oscillatoire est supérieure à la fréquence de seuil haute $F_{SH}$ ou inférieure à la fréquence d'arrêt d'oscillation $F_{osc}$, un début de fraude est détecté. Le dispositif de traitement 1012 fixe alors la valeur de la variable S à « 1 » lors d'une étape 45 et met en oeuvre une étape 46 d'alarme. Lors de l'étape 46 d'alarme, le dispositif de traitement 1012 sauvegarde des informations représentatives du début de fraude. Par exemple, le dispositif de traitement 1012 sauvegarde un horaire de début de fraude et la valeur de la fréquence $F_1$ du signal électrique oscillatoire. Dans un mode de réalisation, lors de la détection d'une fraude, un message contenant les informations représentatives du début de fraude est transmis par le dispositif de détection de fraude 101 à l'équipement central de contrôle 11, qui sauvegarde ces informations pour permettre à un opérateur de les consulter.

L'étape 46 est suivie de l'étape 42 durant laquelle le dispositif de traitement 1012 détermine de nouveau la fréquence $F_1$ du signal électrique oscillatoire. De cette manière, la présence d'un champ magnétique au voisinage du compteur électrique 10 est contrôlée régulièrement.

Si suite à l'étape 44, il apparaît que la fréquence $F_1$ du signal électrique oscillatoire est inférieure à la fréquence de seuil haute $F_{SH}$ et supérieure à la fréquence d'arrêt d'oscillation $F_{osc}$, aucune fraude n'est détectée. Dans ce cas, l'étape 44 est suivie de l'étape 42.

Si lors de l'étape 43, le dispositif de traitement 1012 détermine que la variable S est à la valeur « 1 », l'étape 43 est suivie d'une étape 47. Lors de l'étape 47, le dispositif de traitement 1012 compare la fréquence $F_1$ du signal électrique oscillatoire à au moins une fréquence de seuil comprenant une fréquence de seuil basse $F_{SB}$ et/ou à la fréquence d'arrêt d'oscillation $F_{osc}$. La fréquence de seuil basse $F_{SB}$ est une fréquence supérieure à la fréquence de base et inférieure à la fréquence de seuil haute $F_{SH}$. La fréquence de seuil basse $F_{SB}$ est utilisée pour prendre en compte de faibles oscillations de la fréquence $F_1$ du signal électrique oscillatoire autour de la fréquence de seuil haute $F_{SH}$. En effet, chaque dépassement de la fréquence de seuil haute $F_{SH}$ n'est pas systématiquement significatif d'une nouvelle fraude mais peut être significatif d'une continuation d'une fraude déjà détectée. On considère donc que deux déterminations successives de fréquences $F_1$ du signal électrique oscillatoire supérieures à la fréquence de seuil haute $F_{SH}$ sont significatives de deux fraudes différentes, si entre la première et la seconde des deux déterminations successives, le dispositif de traitement 1012 détermine au moins une fois une fréquence $F_1$ du signal électrique oscillatoire inférieure à la fréquence de seuil basse $F_{SB}$, ce qui permet de créer artificiellement une hystérésis. La fréquence de seuil basse $F_{SB}$ est par exemple déterminée empiriquement lors d'une phase de réglage du compteur électrique 10 en diminuant progressivement un champ magnétique au voisinage du compteur électrique 10 suite à un passage de la fréquence $F_1$ du signal électrique oscillatoire au-delà de la fréquence de seuil haute $F_{SH}$ jusqu'à obtenir une perturbation de la mesure de consommation électrique non significative. Une perturbation non significative peut par exemple être une perturbation telle que moins d'un pourcentage prédéfini, par exemple moins de « 0.05% », d'une consommation électrique réelle n'est pas mesuré par le compteur électrique 10. On peut également, dans la mesure où la fréquence $F_{SH}$ est sensiblement supérieure à la fréquence de base, considérer qu'une hystérésis de 15% de $F_{SH}$ est suffisante. On a donc dans ce cas $F_{SB} = F_{SH}.(1-15\%)$.

Si suite à l'étape 47, il apparaît que la fréquence $F_1$ du signal électrique oscillatoire est comprise entre la fréquence de seuil basse $F_{SB}$ et la fréquence d'arrêt d'oscillation $F_{osc}$, la fin d'une fraude est détectée. Le dispositif de traitement 1012 fixe alors la valeur de la variable S à « 0 » lors d'une étape 48 et passe à une étape 49. Lors de l'étape 49 le dispositif de traitement 1012 sauvegarde des informations représentatives de la fin de fraude et notamment un horaire de fin de fraude et l'associe à l'horaire de début de fraude précédemment sauvegardé. De cette manière, la durée de la fraude peut être déterminée. Dans un mode de réalisation, lors de la détection de la fin d'une fraude, un message contenant les informations représentatives de la fin de fraude est transmis par le dispositif de détection de fraude 101 à l'équipement central de contrôle 11, qui sauvegarde ces informations pour permettre à un opérateur de les consulter. L'étape 49 est suivie de l'étape 42.

Si suite à l'étape 47, il apparaît que la fréquence $F_1$ du signal électrique oscillatoire est supérieure à la fréquence de seuil basse $F_{SB}$ ou inférieure à la fréquence d'arrêt d'oscillation $F_{osc}$, le dispositif de traitement 1012 considère qu'aucune nouvelle fraude n'est détectée. L'étape 47 est alors suivie de l'étape 42.

Dans un mode de réalisation, lors de la détection d'un début de fraude, une diode électroluminescente est allumée sur le dispositif de détection de fraude 101 ou sur le compteur électrique 10 pour signaler l'occurrence d'une fraude.

Dans un mode de réalisation, lors de la détection d'une fraude, les informations représentatives de la fraude sont affichées sur un afficheur compris dans le dispositif de détection de fraude 101 ou dans le compteur électrique 10.

Dans un mode de réalisation, les informations représentatives de la fraude peuvent être consultées par un opérateur en utilisant l'afficheur compris dans le dispositif de détection de fraude 101 ou dans le compteur électrique 10 en utilisant des boutons implantés sur le dispositif de détection de fraude 101 ou dans le compteur électrique 10, ou un clavier connecté sur le dispositif de détection de fraude 101 ou sur le compteur électrique par l'opérateur.

La **Fig. 5** illustre schématiquement un premier algorithme, mis en oeuvre par le dispositif de traitement 1012, pour déterminer une fréquence d'un signal électrique oscillatoire fourni par l'oscillateur électrique 1010 compris dans le dispositif de détection de fraude 101. Ce premier algorithme correspond à l'étape 42 de la Fig. 4. Lors d'une étape 4201, le dispositif de traitement 1012 sauvegarde pendant une période d'analyse $T_A$ des échantillons du signal électrique oscillatoire échantillonné à la fréquence d'échantillonnage $F_E$. Soit $F_{Base}$ la fréquence de base et $T_{Base} = 1/F_{Base}$ une période de base correspondant à la fréquence de base. Dans un mode de réalisation, la période d'analyse $T_A$ est par exemple fixée à un multiple entier de la période de base $T_{Base}$. Dans un autre mode de réalisation, la période d'analyse $T_A$ peut être fixée à un multiple d'une période d'échantillonnage $T_E = 1/F_E$.

Sur une période d'analyse $T_A$, chaque échantillon $E_n$ sauvegardé est numéroté de façon croissante en fonction de son ordre de réception par le dispositif de traitement 1012, la variable $n$ représentant un indice de l'échantillon $E_n$ prenant la valeur 0 pour le premier échantillon reçu pendant la période $T_A$ et la valeur $(N-1)$ pour le dernier échantillon reçu pendant la période $T_A$, $N$ échantillons ayant été reçus pendant la période d'analyse $T_A$. Chaque échantillon $E_n$ est représenté par une valeur de tension $V_n$ et une valeur de temps $t_n$ représentant l'instant d'échantillonnage de l'échantillon.

Dans un mode de réalisation, lors d'une étape 4202, une valeur de décalage $D$ est soustraite à la valeur de tension $V_n$ de chaque échantillon $En$ afin d'obtenir pour chaque échantillon $E_n$ une valeur de tension recalée $U_n$. Dans ce mode de réalisation, la valeur de décalage $D$ est calculée sur une pluralité d'échantillons précédant un échantillon $E_n$ dont la valeur de tension est à recaler. La valeur de décalage $D$ a, par exemple, été calculée sur une période d'analyse $T_A$ précédente comme la moyenne des valeurs de tension des $N$ échantillons $E_n$ de cette période en utilisant la relation suivante :

$$D = \frac{1}{N} \sum_{n=0}^{N-1} V_n$$

et

$$U_n = V_n - D$$

Dans un mode de réalisation, où la valeur de décalage $D$ n'est pas calculée ou lorsque la valeur de décalage est égale à « 0 », $U_n = V_n$.

Dans une étape 4203, la variable $n$ est initialisée à la valeur « 1 » et une variable $N_{zc}$ est initialisée à la valeur « 0 ». La variable $N_{zc}$ est utilisée pour compter un nombre de passages par la valeur « 0 » du signal électrique oscillatoire.

Dans une étape 4204 le dispositif de traitement 1012 détermine si le signal électrique oscillatoire est passé par la valeur « 0 » entre l'instant $t_{n-1}$ et l'instant $t_n$ et si le signal électrique oscillatoire est passé par « 0 », l'instant $t_z$ de passage par la valeur « 0 ». Le dispositif de traitement 1012 identifie un passage par la valeur « 0 » du signal électrique oscillatoire lorsque la valeur de tension recalée $U_n$ de l'échantillon $E_n$ est de signe opposé à la valeur de tension $U_{n-1}$ de l'échantillon $E_{n-1}$. La **Fig. 7** illustre schématiquement un exemple de courbe représentative du signal électrique oscillatoire produit par l'oscillateur électrique 1010. Deux points représentatifs de deux échantillons successifs $E_n$ et $E_{n-1}$ du signal électrique oscillatoire échantillonné sont représentés. Un passage par la valeur « 0 » se produit entre l'échantillon $E_n$ et l'échantillon $E_{n-1}$. La valeur de tension $U_{n-1}$ associée à l'échantillon $E_{n-1}$ est négative alors que la valeur de tension $U_n$ associée à l'échantillon $E_n$ est positive.

Lorsqu'un passage par la valeur « 0 » est identifiée, le dispositif de traitement 1012 incrémente la variable $N_{zc}$ d'une unité. Lors d'une étape 4206, le dispositif de traitement 1012 détermine si le passage par la valeur « 0 » identifié est le premier passage par la valeur « 0 » durant la période d'analyse $T_A$. Si c'est le cas, le dispositif de traitement détermine et sauvegarde lors d'une étape 4208 une valeur d'instant de tout premier passage par la valeur « 0 » $t_{z1}$ égale à l'instant de passage par la valeur « 0 » courant $t_z$.

Si ce n'est pas un premier passage par la valeur « 0 », le dispositif de traitement 1012 sauvegarde lors d'une étape 4207 la valeur de l'instant de passage par la valeur « 0 » courant $t_z$.

L'instant de passage par la valeur « 0 » courant $t_z$ est déterminé en utilisant une méthode d'interpolation linéaire consistant à approximer localement, au voisinage du passage par la valeur « 0 », la courbe représentative du signal électrique oscillatoire par une tangent $\Delta$ passant par les deux points représentatifs des échantillons $E_n$ et $E_{n-1}$.

L'instant de passage par la valeur « 0 » courant $t_z$ est alors calculée de la manière suivante :

$$t_z = \frac{t_{n-1}.U_n - t_n.U_{n-1}}{U_n - U_{n-1}}$$

ou encore en prenant en compte que les échantillons $E_n$ et $E_{n-1}$ sont séparés d'une période de temps correspondant à la période d'échantillonnage $T_E$ :

$$t_z = \frac{\big((n-1).U_n - n.U_{n-1}\big).T_E}{U_n - U_{n-1}}$$

Le dispositif de traitement 1012 sauvegarde alors une valeur de l'instant de premier passage par zéro $t_{z1}$ égale à l'instant de passage par la valeur « 0 » courant $t_z$ calculé.

Les étapes 4207 et 4208 (ou l'étape 4204 lorsque le dispositif de traitement 1012 ne détecte pas de passage par la valeur « 0 ») sont suivies d'une étape 4209 au cours de laquelle la variable $n$ est incrémentée d'une unité. Lors d'une étape 4210, le dispositif de traitement 1012 compare la variable $n$ à la variable $N$ correspondant au nombre d'échantillons pendant la période d'analyse $T_A$. Si la variable $n$ est inférieure à la variable $N$, le dispositif de traitement met de nouveau en oeuvre l'étape 4204.

Si la variable $n$ est supérieure ou égale à la variable $N$, le dispositif de traitement 1012 sauvegarde dans une étape 4211 un instant $t_{z2}$ correspondant au tout dernier passage par la valeur « 0 » du signal électrique oscillatoire. Lorsque la variable $N_{ZC}$ est paire, l'instant $t_{z2}$ du dernier passage par la valeur « 0 » du signal électrique oscillatoire correspond au dernier instant de passage par la valeur « 0 » $t_z$ calculée par le dispositif de traitement 1012. Si la variable $N_{ZC}$ est impaire, l'instant $t_{z2}$ du dernier passage par la valeur « 0 » du signal électrique oscillatoire correspond à l'instant de passage par la valeur « 0 » $t_z$ précédant le dernier instant de passage par la valeur « 0 » $t_z$ calculée par le dispositif de traitement 1012. Dans ce cas la variable $N_{ZC}$ est décrémentée d'une unité.

La fréquence $F_1$ du signal électrique oscillatoire est alors obtenue dans une étape 4212 par la relation suivante :

$$F_1 = \left(\frac{t_{z2} - t_{z1}}{\left(\frac{N_{ZC}}{2}\right) - 1}\right)^{-1}$$

Dans un mode de réalisation particulier, le dispositif de traitement 1012 ne recherche que les passages par la valeur « 0 » du signal électrique oscillatoire sur un front de signal montant (resp. un front de signal descendant). Un front de signal montant (resp. descendant) est défini comme une partie du signal électrique oscillatoire dans laquelle, pour tout couple d'échantillons successifs $E_{n-1}$ et $E_n$, la valeur de tension $U_n$ de l'échantillon $E_n$ est supérieure (resp. inférieure) à la valeur de tension $U_{n-1}$ de l'échantillon $E_{n-1}$.

Dans ce mode de réalisation particulier, la fréquence $F_1$ du signal électrique oscillatoire est alors obtenue lors de l'étape 4212 par la relation suivante, sachant que dans ce cas il n'y a aucun traitement spécifique lié à la parité de $N_{ZC}$ :

$$F_1 = \left(\frac{t_{z2} - t_{z1}}{N_{ZC} - 1}\right)^{-1}$$

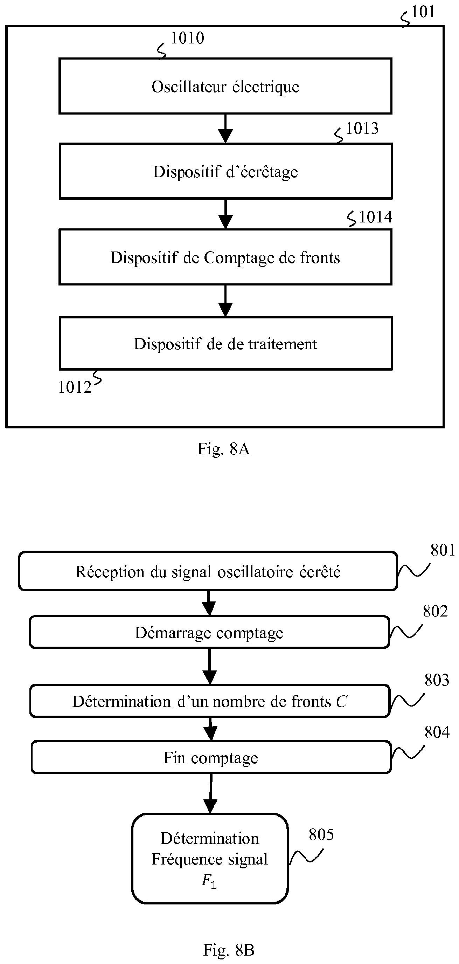

La **Fig. 8A** illustre schématiquement un second exemple de dispositif de détection de fraude 101 selon l'invention. Ce dispositif de détection de fraude 101 comprend un oscillateur électrique 1010 et un dispositif de traitement 1012 respectivement identiques à l'oscillateur électrique 1010 et au dispositif de traitement 1012 décrit en relation avec la Fig. 2. Dans ce second exemple, le dispositif de détection de fraude comprend un dispositif d'écrêtage 1013 et un dispositif de comptage de fronts 1014. Lorsqu'il reçoit le signal électrique oscillatoire, le dispositif d'écrêtage 1013 applique une limitation d'une valeur crête à crête au signal électrique oscillatoire afin d'obtenir un signal électrique oscillatoire écrêté. Le signal électrique oscillatoire écrêté obtenu est alors transmis au dispositif de comptage de front qui est apte à déterminer un nombre de fronts (montants et/ou descendants) $C$ dans le signal électrique oscillatoire écrêté. Le dispositif de traitement 1012 met en oeuvre l'algorithme permettant de détecter la présence d'un champ magnétique au voisinage du compteur électrique 10 décrit en relation avec la Fig. 4. Pour ce faire, le dispositif de comptage de fronts 1013 transmet régulièrement des informations représentatives de nombres de fronts $C$ dans le signal électrique oscillatoire écrêté au dispositif de traitement 1012 pour qu'il puisse déterminer régulièrement la fréquence $F_1$ du signal électrique oscillatoire.

La **Fig. 8B** illustre schématiquement un second algorithme, mis en oeuvre conjointement par le dispositif de comptage de fronts 1014 et par le dispositif de traitement 1012, pour déterminer la fréquence $F_1$ du signal électrique oscillatoire fourni par l'oscillateur électrique 1010 compris dans le dispositif de détection de fraude 101. Ce second algorithme est mis en oeuvre lors de l'étape 42 lorsque le dispositif de détection de fraude 101 est celui décrit en relation avec la Fig. 8A. Dans une étape 801, le dispositif de comptage de fronts 1014 reçoit le signal oscillatoire écrêté de la part du dispositif d'écrêtage 1013. Lors d'une étape 802, le dispositif de traitement 1012 transmet un ordre de démarrage de comptage de fronts au dispositif de comptage de fronts 1014. Suite à la réception de l'ordre de démarrage du comptage de fronts, le dispositif de comptage de fronts 1014 initialise une variable *C* à la valeur « 0 » et lance le comptage des fronts en incrémentant la variable C d'une unité à chaque fois qu'un front montant et/ou descendant est identifié dans le signal électrique oscillatoire écrêté. Au bout d'une période d'analyse $T_A$, le dispositif de traitement 1012 transmet lors d'une étape 804 un ordre de fin de comptage au dispositif de comptage de fronts 1014 pour qu'il cesse le comptage des fronts. Dans une étape 805, le dispositif de traitement 1012 obtient la valeur de la variable *C* et détermine la valeur de la fréquence $F_1$ du signal électrique oscillatoire en utilisant la relation suivante si les fronts montants et descendants sont comptés :

$$F_1 = \frac{C}{2.T}$$

et en utilisant la relation suivante si seuls les fronts montants (resp. descendant) sont comptés.

$$F_1 = \frac{C}{T}$$

Un opérateur peut utiliser les informations représentatives de chaque début et fin de fraude obtenues sur l'équipement central de contrôle ou par l'intermédiaire de l'afficheur du dispositif de détection de fraude 101 ou du compteur électrique 10 pour constater une fraude et déterminer l'étendue de la fraude.

**Revendications**

1. Procédé de détection d'une fraude visant à perturber une mesure de consommation électrique par un compteur électrique (10) et consistant à appliquer un champ magnétique dans un voisinage du compteur électrique, le procédé étant mis en oeuvre par un dispositif de détection de fraude (101) associé au compteur électrique, caractérisé en ce le procédé comprend les étapes suivantes :

   - déterminer (42) sur une première période de temps une fréquence d'un signal électrique oscillatoire fourni par un oscillateur électrique (1010) compris dans le dispositif de détection de fraude et comprenant un bobinage muni d'un noyau ferromagnétique isotrope (605), le bobinage muni du noyau ferromagnétique isotrope ayant une première valeur d'inductance en l'absence de champ magnétique au voisinage du compteur électrique et ayant au moins une seconde valeur d'inductance, différente de la première valeur d'inductance, en présence au voisinage du compteur électrique d'au moins un champ magnétique apte à modifier une perméabilité magnétique du noyau ferromagnétique isotrope, ladite fréquence du signal électrique oscillatoire dépendant de la valeur d'inductance du bobinage muni du noyau ferromagnétique,
   - comparer (44, 47) la fréquence du signal électrique oscillatoire déterminée avec au moins une fréquence de seuil, et
   - détecter (46, 49) la fraude en fonction d'un résultat de la comparaison.

2. Procédé selon la revendication 1, **caractérisé en ce que** le dispositif de détection de fraude détecte (44) une première fraude lorsque, sur la première période de temps, la fréquence du signal électrique oscillatoire déterminée est supérieure à une fréquence de seuil haute ou lorsque la fréquence du signal électrique oscillatoire déterminée est inférieure à une fréquence d'arrêt d'oscillation inférieure à la fréquence de seuil haute.

3. Procédé selon la revendication 2, **caractérisé en ce que**, suite à la détection de la première fraude sur la première période de temps, le dispositif de détection de fraude détecte (44) une seconde fraude sur une deuxième période de temps suivant la première période de temps, si durant une troisième période de temps intermédiaire entre la première et la seconde période de temps, la fréquence du signal électrique oscillatoire est inférieure à une fréquence de seuil basse et supérieure à la fréquence d'arrêt d'oscillation (47), la fréquence de seuil basse étant inférieure à la fréquence de seuil haute et supérieure à la fréquence d'arrêt d'oscillation.

4. Procédé selon la revendication 1, 2 ou 3 **caractérisé en ce que**, lors de chaque détermination de la fréquence du signal électrique oscillatoire sur une période de temps, le dispositif de détection de fraude détermine (4204, 4205) un nombre de passages par zéro sur un front montant et/ou descendant d'un signal résultant d'un échantillonnage du signal électrique oscillatoire pendant ladite période de temps, la fréquence du signal oscillatoire étant fonction du nombre de passages par zéro déterminé pendant ladite période de temps et d'une durée séparant le tout premier instant de passage par zéro pendant ladite période de temps et le tout dernier instant de passage par zéro pendant ladite période de temps, **et en ce que** tout passage par zéro est identifié lorsque deux échantillons successifs du signal résultant de l'échantillonnage du signal électrique oscillatoire sont de signes opposés, chaque instant de passage par zéro étant estimé (4207, 4208) en effectuant une interpolation linéaire entre lesdits échantillons successifs.

5. Procédé selon la revendication 4, **caractérisé en ce**

**que** chaque échantillon du signal résultant de l'échantillonnage du signal électrique oscillatoire est associé à une valeur de tension et **en ce que**, lors de la détermination de la fréquence du signal électrique oscillatoire, le dispositif de détection de fraude utilise pour chaque échantillon, une valeur de tension recalée obtenue en soustrayant (4202) une valeur de décalage à la valeur de tension associée audit échantillon, la valeur de décalage utilisée pour ledit échantillon étant une moyenne des valeurs de tension associées à une pluralité d'échantillons précédant ledit échantillon dont la valeur de tension est à recaler.

6. Procédé selon la revendication 1, 2 ou 3, **caractérisé en ce que** lors de chaque détermination de la fréquence du signal électrique oscillatoire sur une période de temps, le dispositif de détection de fraude utilise un dispositif d'écrêtage (1013) compris dans le dispositif de détection de fraude pour appliquer une limitation d'une valeur crête à crête au signal électrique oscillatoire afin d'obtenir un signal écrêté et détermine (805) la fréquence du signal électrique oscillatoire en fonction d'un nombre de fronts dans le signal écrêté pendant ladite période de temps.

7. Procédé selon l'une quelconque des revendications précédentes, **caractérisé en ce que** l'oscillateur électrique est parmi la liste suivante :

   - oscillateur de Colpitts,
   - oscillateur de Clapp, et
   - oscillateur de Hartley.

8. Dispositif 101 de détection de fraude visant à empêcher une mesure de consommation électrique par un compteur électrique (10) et consistant à appliquer un champ magnétique dans un voisinage du compteur électrique, caractérisé en ce le dispositif comprend :

   - des moyens pour déterminer (42, 1011, 1012, 1013, 1014) sur une première période de temps une fréquence d'un signal électrique oscillatoire fourni par un oscillateur électrique (1010) compris dans le dispositif de détection de fraude et comprenant un bobinage muni d'un noyau ferromagnétique isotrope (605), le bobinage muni du noyau ferromagnétique isotrope ayant une première valeur d'inductance en l'absence de champ magnétique au voisinage du compteur électrique et ayant au moins une seconde valeur d'inductance en présence au voisinage du compteur électrique d'au moins un champ magnétique apte à modifier la perméabilité magnétique du noyau ferromagnétique isotrope , ladite fréquence du signal électrique oscillatoire dépendant de la valeur d'inductance du bobinage muni du noyau ferromagnétique,
   - des moyens pour comparer (44, 47, 1012) la fréquence du signal électrique oscillatoire déterminée avec au moins une fréquence de seuil, et
   - des moyens pour détecter (46, 49, 1012) la fraude en fonction du résultat de la comparaison.

9. Compteur électrique (10), **caractérisé en ce qu'**il comprend le dispositif de détection de fraude selon la revendication 8

10. Système comprenant un compteur électrique (10) selon la revendication 9 et un équipement central de contrôle (11), **caractérisé en ce que** le compteur électrique transmet des informations représentatives d'une fraude à l'équipement central de contrôle.

11. Produit programme d'ordinateur, **caractérisé en ce qu'**il comporte des instructions pour mettre en oeuvre, par un dispositif, le procédé selon l'une quelconque des revendications 1 à 8 par un processeur du dispositif.

12. Moyens de stockage, **caractérisés en ce qu'**ils stockent un programme d'ordinateur comportant des instructions pour mettre en oeuvre, par un dispositif, le procédé selon l'une quelconque des revendications 1 à 8 lorsque ledit programme est exécuté par un processeur du dispositif.

**Patentansprüche**

1. Verfahren zur Erkennung eines Betrugs, der darauf abzielt, eine Messung eines Stromverbrauchs durch einen Stromzähler (10) zu stören, und darin besteht, ein Magnetfeld in der Nähe des Stromzählers anzulegen, wobei das Verfahren von einer Vorrichtung zur Betrugserkennung (101) durchgeführt wird, die dem Stromzähler zugeordnet ist, **dadurch gekennzeichnet, dass** das Verfahren die folgenden Schritte umfasst:

   - Bestimmen (42), über einen ersten Zeitraum, einer Frequenz eines elektrischen Schwingungssignals, das von einem elektrischen Oszillator (1010) geliefert wird, der in der Vorrichtung zur Betrugserkennung enthalten ist und eine Wicklung umfasst, die mit einem isotropen ferromagnetischen Kern (605) ausgestattet ist, wobei die mit dem isotropen ferromagnetischen Kern ausgestattete Wicklung einen ersten Induktivitätswert bei Nichtvorhandensein eines Magnetfelds in der Nähe des Stromzählers aufweist und wenigstens einen zweiten Induktivitätswert, der von dem ersten Induktivitätswert verschieden ist, bei Vorhandensein wenigstens eines Magnetfelds in der Nähe des Stromzählers aufweist, das geeignet ist, eine magnetische Permeabilität des isotropen ferromagnetischen Kerns zu ändern, wobei die Frequenz des elektrischen Schwingungssignals von dem Induktivitätswert der Wicklung abhängt, die mit dem ferromagnetischen Kern ausgestattet ist,
- Vergleichen (44, 47) der bestimmten Frequenz des elektrischen Schwingungssignals mit wenigstens einer Schwellenwertfrequenz, und
- Erkennen (46, 49) des Betrugs in Abhängigkeit von einem Ergebnis des Vergleichs.

2. Verfahren nach Anspruch 1, **dadurch gekennzeichnet, dass** die Vorrichtung zur Betrugserkennung einen ersten Betrug erkennt (44), wenn über dem ersten Zeitraum die bestimmte Frequenz des elektrischen Schwingungssignals höher als eine obere Schwellenwertfrequenz ist, oder wenn die bestimmte Frequenz des elektrischen Schwingungssignals niedriger als eine Schwingungsstopp-Frequenz ist, die niedriger als die obere Schwellenwertfrequenz ist.

3. Verfahren nach Anspruch 2, **dadurch gekennzeichnet, dass** im Anschluss an die Erkennung des ersten Betrugs über dem ersten Zeitraum die Vorrichtung zur Betrugserkennung einen zweiten Betrug über einem zweiten Zeitraum erkennt (44), der auf den ersten Zeitraum folgt, falls während eines dritten Zeitraums, der zwischen dem ersten und dem zweiten Zeitraum liegt, die Frequenz des elektrischen Schwingungssignals niedriger als eine untere Schwellenwertfrequenz und höher als die Schwingungsstopp-Frequenz ist (47), wobei die untere Schwellenwertfrequenz niedriger als die obere Schwellenwertfrequenz und höher als die Schwingungsstopp-Frequenz ist.

4. Verfahren nach Anspruch 1, 2 oder 3, **dadurch gekennzeichnet, dass** bei jeder Bestimmung der Frequenz des elektrischen Schwingungssignals über einem Zeitraum die Vorrichtung zur Betrugserkennung eine Anzahl von Nulldurchgängen an einer steigenden und/oder fallenden Flanke eines Signals bestimmt (4204, 4205), das aus einer Abtastung des elektrischen Schwingungssignals während des Zeitraums resultiert, wobei die Frequenz des Schwingungssignals von der bestimmten Anzahl von Nulldurchgängen während des Zeitraums und von einer Dauer, die den allerersten Zeitpunkt eines Nulldurchgangs während des Zeitraums und den allerletzten Zeitpunkt eines Nulldurchgangs während des Zeitraums trennt, abhängt, und dadurch, dass jeder Nulldurchgang identifiziert wird, wenn zwei aufeinander folgende Abtastwerte des Signals, das aus der Abtastung des elektrischen Schwingungssignals resultiert, entgegengesetzte Vorzeichen haben, wobei jeder Zeitpunkt eines Nulldurchgangs geschätzt wird (4207, 4208), indem eine lineare Interpolation zwischen den aufeinander folgenden Abtastwerten durchgeführt wird.

5. Verfahren nach Anspruch 4, **dadurch gekennzeichnet, dass** jeder Abtastwert des Signals, das aus der Abtastung des elektrischen Schwingungssignals resultiert, einem Spannungswert zugeordnet ist, und dadurch, dass bei der Bestimmung der Frequenz des elektrischen Schwingungssignals die Vorrichtung zur Betrugserkennung für jeden Abtastwert einen neu justierten Spannungswert verwendet, der erhalten wird, indem ein Versatzwert von dem Spannungswert, der dem Abtastwert zugeordnet ist, subtrahiert wird (4202), wobei der für den Abtastwert verwendete Versatzwert ein Mittelwert der Spannungswerte ist, die einer Vielzahl von Abtastwerten zugeordnet sind, die dem Abtastwert vorangehen, dessen Spannungswert neu zu justieren ist.

6. Verfahren nach Anspruch 1, 2 oder 3, **dadurch gekennzeichnet, dass** bei jeder Bestimmung der Frequenz des elektrischen Schwingungssignals über einem Zeitraum die Vorrichtung zur Betrugserkennung eine Spitzenbegrenzungsvorrichtung (1013) verwendet, die in der Vorrichtung zur Betrugserkennung enthalten ist, um eine Begrenzung eines Spitze-Spitze-Wertes auf das elektrische Schwingungssignal anzuwenden, um ein spitzenbegrenztes Signal zu erhalten, und die Frequenz des elektrischen Schwingungssignals in Abhängigkeit von einer Anzahl von Flanken in dem spitzenbegrenzten Signal während des Zeitraums bestimmt (805).

7. Verfahren nach einem der vorhergehenden Ansprüche, **dadurch gekennzeichnet, dass** der elektrische Oszillator von einem der folgenden Typen ist:

   - Colpitts-Oszillator,
   - Clapp-Oszillator und
   - Hartley-Oszillator.

8. Vorrichtung (101) zur Erkennung eines Betrugs, der darauf abzielt, eine Messung eines Stromverbrauchs durch einen Stromzähler (10) zu verhindern, und darin besteht, ein Magnetfeld in der Nähe des Stromzählers anzulegen, **dadurch gekennzeichnet, dass** die Vorrichtung umfasst:

   - Mittel zum Bestimmen (42, 1011, 1012, 1013, 1014), über einen ersten Zeitraum, einer Frequenz eines elektrischen Schwingungssignals, das von einem elektrischen Oszillator (1010) geliefert wird, der in der Vorrichtung zur Betrugserkennung enthalten ist und eine Wicklung umfasst, die mit einem isotropen ferromagnetischen Kern (605) ausgestattet ist, wobei die mit dem isotropen ferromagnetischen Kern ausgestattete Wicklung einen ersten Induktivitätswert bei Nichtvorhandensein eines Magnetfelds in der Nähe des Stromzählers aufweist und wenigstens einen zweiten Induktivitätswert bei Vorhandensein wenigstens eines Magnetfelds in der Nähe des Stromzählers aufweist, das geeignet ist, die magnetische Permeabilität des isotropen ferromagnetischen Kerns zu ändern, wobei die Frequenz des elektrischen Schwingungssignals von dem Induktivitätswert der Wicklung abhängt, die mit dem ferromagnetischen Kern ausgestattet ist,

- Mittel zum Vergleichen (44, 47, 1012) der bestimmten Frequenz des elektrischen Schwingungssignals mit wenigstens einer Schwellenwertfrequenz, und

- Mittel zum Erkennen (46, 49, 1012) des Betrugs in Abhängigkeit vom Ergebnis des Vergleichs.

9. Stromzähler (10), **dadurch gekennzeichnet, dass** er die Vorrichtung zur Erkennung eines Betrugs nach Anspruch 8 umfasst.

10. System, welches einen Stromzähler (10) nach Anspruch 9 und eine zentrale Steuereinrichtung (11) umfasst, **dadurch gekennzeichnet, dass** der Stromzähler Informationen, die für einen Betrug repräsentativ sind, an die zentrale Steuereinrichtung überträgt.

11. Computerprogrammprodukt, **dadurch gekennzeichnet, dass** es Anweisungen zur Durchführung, durch eine Vorrichtung, des Verfahrens nach einem der Ansprüche 1 bis 8 durch einen Prozessor der Vorrichtung umfasst.

12. Speichermittel, **dadurch gekennzeichnet, dass** sie ein Computerprogramm speichern, das Anweisungen zur Durchführung des Verfahrens nach einem der Ansprüche 1 bis 8 mittels einer Vorrichtung, wenn das Programm von einem Prozessor der Vorrichtung ausgeführt wird, umfasst.

**Claims**

1. Method for detecting an act of fraud aiming to interfere with a measurement of electrical consumption by an electric meter (10) and consisting of applying a magnetic field in the vicinity of the electric meter, the method being implemented by a fraud detection device (101) associated with the electric meter, **characterized in that** the method comprises the following steps:

- determining (42), in a first period of time, a frequency of an oscillating electrical signal delivered by an electrical oscillator (1010) included in the fraud detection device and comprising a winding equipped with an isotropic ferromagnetic core (605), the winding equipped with the isotropic ferromagnetic core having a first inductance value in the absence of magnetic field in the vicinity of the electric meter and having at least a second inductance value, different from the first inductance value, in the presence of at least one magnetic field, in the vicinity of the electric meter, that is capable of modifying a magnetic permeability of the isotropic ferromagnetic core, said frequency of the oscillating electrical signal depending on the inductance value of the winding equipped with the ferromagnetic core;

- comparing (44, 47) the frequency of the determined oscillating electrical signal with at least one threshold frequency; and

- detecting (46, 49) the act of fraud depending on an outcome of the comparison.

2. Method according to Claim 1, **characterized in that** the fraud detection device detects (44) a first act of fraud when, in the first period of time, the frequency of the determined oscillating electrical signal is higher than an upper threshold frequency or when the frequency of the determined oscillating electrical signal is lower than an oscillation stop frequency below the upper threshold frequency.

3. Method according to Claim 2, **characterized in that**, subsequent to the detection of the first act of fraud in the first period of time, the fraud detection device detects (44) a second act of fraud in a second period of time following the first period of time if, in a third period of time intermediate between the first and the second periods of time, the frequency of the oscillating electrical signal is lower than a lower threshold frequency and higher than the oscillation stop frequency (47), the lower threshold frequency being lower than the upper threshold frequency and higher than the oscillation stop frequency.

4. Method according to Claim 1, 2 or 3 **characterized in that**, during each determination of the frequency of the oscillating electrical signal in a period of time, the fraud detection device determines (4204, 4205) a number of zero crossings on a rising and/or falling edge of a signal resulting from a sampling of the oscillating electrical signal in said period of time, the frequency of the oscillating signal being a function of the number of zero crossings determined in said period of time and of a duration separating the very first instant in time of a zero crossing in said period of time and the very last instant in time of a zero crossing in said period of time,
and **in that** every zero crossing is identified when two successive samples of the signal resulting from the sampling of the oscillating electrical signal are of opposite signs, each instant in time of a zero crossing being estimated (4207, 4208) by carrying out a linear interpolation between said successive samples.

5. Method according to Claim 4, **characterized in that** each sample of the signal resulting from the sampling of the oscillating electrical signal is associated with a voltage value and **in that**, during the determination of the frequency of the oscillating electrical signal, the fraud detection device uses, for each sample, an adjusted voltage value obtained by subtracting (4202) an offset value from the voltage value associated with said sample, the offset value used for said sample being a mean of the voltage values associated with a plurality of samples preceding said sample whose voltage value is to be adjusted.

6. Method according to Claim 1, 2 or 3, **characterized in that** during each determination of the frequency of the oscillating electrical signal in a period of time, the fraud detection device uses a clipping device (1013) included in the fraud detection device in order to apply a limitation of a peak-to-peak value to the oscillating electrical signal in order to obtain a clipped signal and determines (805) the frequency of the oscillating electrical signal according to a number of edges in the clipped signal in said period of time.

7. Method according to any one of the preceding claims, **characterized in that** the electrical oscillator is from the following list:

   - Colpitts oscillator;
   - Clapp oscillator; and
   - Hartley oscillator.

8. Device 101 for detecting an act of fraud aiming to interfere with a measurement of electrical consumption by an electric meter (10) and consisting of applying a magnetic field in the vicinity of the electric meter, **characterized in that** this device comprises:

   - means for determining (42, 1011, 1012, 1013, 1014), in a first period of time, a frequency of an oscillating electrical signal delivered by an electrical oscillator (1010) included in the fraud detection device and comprising a winding equipped with an isotropic ferromagnetic core (605), the winding equipped with the isotropic ferromagnetic core having a first inductance value in the absence of magnetic field in the vicinity of the electric meter and having at least a second inductance value in the presence of at least one magnetic field, in the vicinity of the electric meter, that is capable of modifying a magnetic permeability of the isotropic ferromagnetic core, said frequency of the oscillating electrical signal depending on the inductance value of the winding equipped with the ferromagnetic core;
   - means for comparing (44, 47, 1012) the frequency of the determined oscillating electrical signal with at least one threshold frequency; and
   - means for detecting (46, 49, 1012) the act of fraud depending on an outcome of the comparison.

9. Electric meter (10), **characterized in that** it comprises the fraud detection device according to Claim 8.

10. System comprising an electric meter (10) according to Claim 9 and a central control unit (11), **characterized in that** the electric meter transmits information representative of an act of fraud to the central control unit.

11. Computer program product, **characterized in that** it comprises instructions for implementing, by a device, the method according to any one of Claims 1 to 8 by a processor of the device.

12. Storage means, **characterized in that** they store a computer program comprising instructions for implementing, by a device, the method according to any one of Claims 1 to 8 when said program is executed by a processor of the device.

Fig. 1A

Fig. 1B

Fig. 2

Fig. 3

Procédé de détermination de fréquence d'un signal fourni par un oscillateur — 42

S=0? — 43

oui: $F_1 > F_{SH}$ ou $F_1 < F_{OSC}$? — 44

S=1 — 45

Fraude détectée — 46

$F_1 < F_{SB}$ et $F_1 > F_{OSC}$? — 47

S=0 — 48

Pas de Fraude — 49

Fig. 4

Fig. 5

Fig. 6

Fig. 7

101

1010

Oscillateur électrique

1013

Dispositif d'écrêtage

1014

Dispositif de Comptage de fronts

Dispositif de de traitement

1012

Fig. 8A

Réception du signal oscillatoire écrêté — 801

Démarrage comptage — 802

Détermination d'un nombre de fronts $C$ — 803

Fin comptage — 804

Détermination
Fréquence signal
$F_1$ — 805

Fig. 8B

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- CH 604183
- WO 2008065291 A2
- US 1624537 A
- US 1356763 A

**Littérature non-brevet citée dans la description**

- **J. K. CLAPP.** An inductance-capacitance oscillator of unusual frequency stability. *Proc. IRE,* Mars 1948, vol. 367, 356-358